# EUROPEAN PATENT APPLICATION

(11) **EP 4 626 169 A1**
(43) Date of publication of application: **01.10.2025**
(21) Application number: 25165754.0
(22) Date of filing: 24.03.2025
(51) Int. Cl.: H10D 62/10, H10D 30/01, H10D 30/00, H10D 30/62, H10D 30/67, H10D 30/69, H10D 62/13

(54) **SOURCE AND DRAIN STRUCTURES PROVIDING HIGHLY CONDUCTIVE CONTACT INTERFACE AND STRAIN TO MOSFET CHANNEL**

(30) Priority: 29.03.2024 US 202418621973
(71) Applicant: Intel Corporation, Santa Clara, CA 95054 (US)
(72) Inventor: CHEN, Zhiyi, Portland, 97229 (US); MURTHY, Anand, Portland, 97229 (US); BADMAEV, Alexander, Portland, 97229 (US); CHOUKSEY, Siddharth, Portland, 97229 (US); KALLY CHEN, Yixuan, Hillsboro, 97124 (US)
(74) Representative: 2SPL Patentanwälte PartG mbB

(57) **Abstract**

Epitaxial source and drain structures providing strain to transistor channels. A transistor structure may have a channel between substantially monocrystalline source and drain regions, each crystalline region having both liner and intervening portions. The crystalline regions may be of silicon and germanium. The liner portion may be in contact with the channel and a substrate under the crystalline regions and have a composition different than that of the intervening portion. The intervening portion may have a higher proportion of germanium and a greater average lattice constant than the liner portion. The crystalline regions may include a dopant (such as boron) in the liner and/or intervening portions. In crystalline regions having boron, the regions may have boron-11 and boron-10 at approximately the naturally occurring proportions, e.g., about 4:1. A low-resistivity contact layer, e.g., including gallium, may be at or on the crystalline region.

## Description

### BACKGROUND

Modern transistors frequently rely on source and drain structures providing strain to transistor channels for increased device conductivity. For example, some p-type field-effect transistors (FETs) may require source and drain structures to exert compressive strain on p-type channels to maximize performance. However, in some cutting-edge transistors, such as gate-all-around (GAA) FETs, source and drain epitaxial growth is initiated from the multiple growth fronts of multiple nanoribbons (nanowires, nanosheets, etc.). Crystalline defects form when and where those multiple growth fronts merge and interfere with the exertion of sufficient, uniform strain on the multiple channel structures. Insufficient strain limits maximum device conductivity, and uneven strain on various channel structures causes nonuniform current densities between the multiple channel structures.

As device sizes are reduced, device conductivities may be limited by increased contact resistances of scaled-down source and drain contacts, even with properly strained channels.

New techniques, structures, and materials are needed to improve conductivities of source and drain structures in contemporary FET devices.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIG. 1 illustrates a cross-sectional profile view of an integrated circuit (IC) apparatus or device and a transistor structure having source or drain regions with a substantially monocrystalline portion along at least a full height of a channel region, in accordance with some embodiments;
FIGS. 2A, 2B, and 2C illustrate cross-sectional profile views of transistor structures having various source and drain regions in IC devices, in accordance with some embodiments;
FIG. 3 illustrates a cross-sectional profile view of a source or drain region coupled with a metallization structure by a highly conductive contact section, in accordance with some embodiments;
FIGS. 4A and 4B illustrate cross-sectional profile views of a metallization structure situated in a notch in a source or drain region and between crystallographic facets of the source or drain region, in accordance with some embodiments;
FIG. 5 is a flow chart of methods for forming a substantially monocrystalline source or drain region between adjacent channel regions, in accordance with some embodiments;
FIGS. 6A, 6B, 6C, 6D, and 6E illustrate cross-sectional profile views of an IC device having a substantially monocrystalline source or drain region between adjacent channel regions, at various stages of manufacture, in accordance with some embodiments;
FIG. 7 illustrates a diagram of an example data server machine employing an IC device having source and drain regions epitaxially grown bottom-up, in accordance with some embodiments; and
FIG. 8 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed for forming integrated circuit (IC) devices having improved transistors with channel regions between source and drain structures, for example, non-planar, p-type metal-oxide semiconductor (pMOS) transistors with epitaxially formed source and drain regions. Improved source and drain regions may provide strain on a channel region therebetween and thereby increase field-effect transistor (FET) conductance and reliability. Improved source and drain regions in pMOSFETs may provide compressive strain and so increase conductance and reliability. Further enhancement of source and drain regions may include, in addition to a first dopant epitaxially incorporated throughout the source and drain regions during growth, the introduction of a second dopant at an upper surface may form a low-resistivity contact layer.

A defect-free crystalline film layer may be epitaxially grown upwards from a bottom of or below a channel region to a top or above the channel region as a liner part of an improved source or drain structure. The high-quality epitaxial (or epi) layer may provide a united front for the transmission of a force to the channel region, e.g., as a crystalline force plate on one or both ends of a transistor channel. For example, a p-type epi layer may act as a compression plate for exerting a compressive strain on the channel region. While such an epi layer may be beneficial for various transistor structures, such as FinFETs, the united front may be particularly advantageous for gate-all-around (GAA) FETs. GAA FETs may employ multiple channel structures (such as nanoribbons) in each channel region, and conventional source and drain structures encounter challenges to properly straining (e.g., uniformly, evenly straining) associated channel structures.

For example, typical GAA pMOSFET source and drain structures may interface with and be formed from multiple, individual nanoribbons in a stack, and defects may also form in the source and drain structures when and where multiple growth fronts merge. These defects and misaligned growth fronts may inhibit the source and drain structures from producing and/or transmitting a sufficient and uniform compressive force to the channel region. While some of the nanoribbons may be compressively strained, the compression may be diminished, and some of the nanoribbons may even be tensilely strained. Such variation in strains may cause corresponding disparities in current densities through the multiple nanoribbons, resulting in reduced performance and reliability.

In addition to providing for the uniform application of sufficient (e.g., compressive) forces on individual channel structures, an epitaxial liner layer grown bottom-up (rather from multiple, individual channel structures) may otherwise enable source and drain structures with superior electrical characteristics. The epitaxial growth may include a dopant, which may incorporate the dopant into the lattice more effectively than, for example, a dopant subsequently implanted. This superior dopant incorporation may yield a higher proportion of active dopant and result in more-conductive source and drain epi material (e.g., relative to implanting the dopant, which may deposit more inactive, interstitial dopant atoms between lattice locations). A top layer or section of the source and drain epi material may provide a low-resistivity contact interface, e.g., to a metallization structure (such as a contact via) above the source or drain structure.

Epi liner layers spanning from below to above channel regions may be source and drain sidewalls on both sides of a source or drain structure and leave plenty of space for a bulk or fill epi portion with higher conductivity between the sidewall layers. The distinct first and second epi portions may be deposited with different compositions optimized for their different functions or material applications. The first, sidewall epi layers may serve as a growth template for the second, highly conductive epi layer or portion. The second epi portion may be grown with a higher conductivity and a greater lattice constant to exert an outward force to compress channel regions (e.g., between adjacent source or drain structures). For example, in source and drain structures of silicon and germanium, the second, central epi portion (between the first, sidewall portion(s)) may have a higher proportion of germanium. The second epi portion may also be grown with more of a dopant for increased conductivity. An upper layer or section of the second epi portion may also be doped with a different, additional dopant for increased conductivity and to provide a contact interface with reduced contact resistivity, for example, a contact resistivity ρ_{c} < 2e-9 Ω·cm². For example, gallium may be a second dopant deployed in a contact layer to increase conductivity beyond a limit of a first dopant (such as boron).

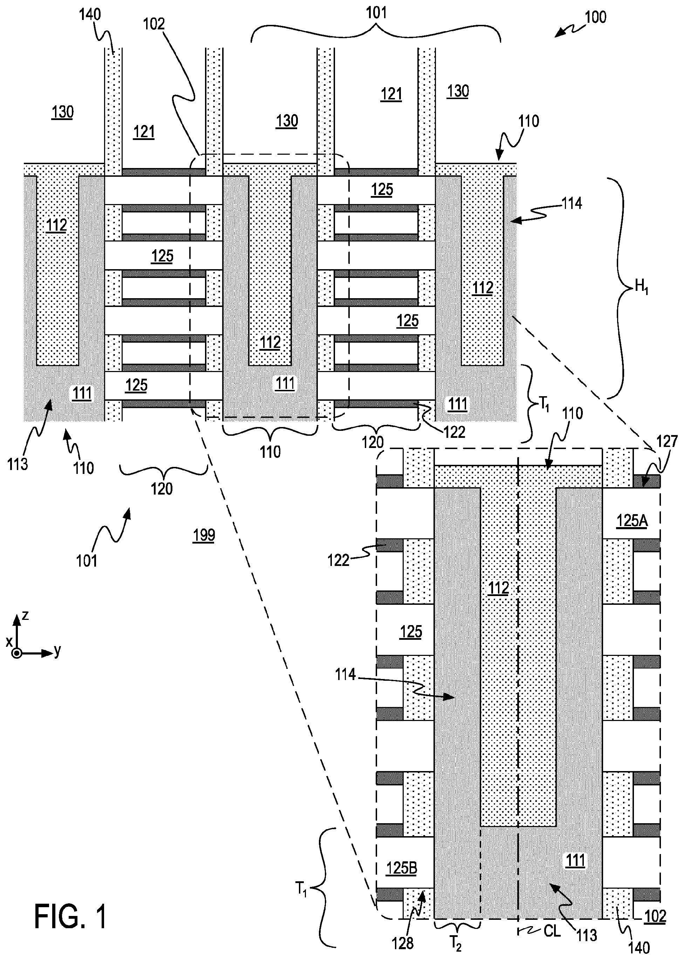

FIG. 1 illustrates a cross-sectional profile view of an IC apparatus or device 100 and a transistor structure 101 having source or drain regions 110 with a substantially monocrystalline portion 111 along at least a full height H₁ of channel region 120, in accordance with some embodiments. Portion 111 may be substantially monocrystalline and may provide a substantially continuous plane for compression (e.g., in the y-dimension) of channel region 120. The uninterrupted plane may be especially beneficial for compression of channel regions 120 having multiple, separate current paths, e.g., in a stack of nanoribbons 125. Second portion 112 may be monocrystalline and may exert a compressive force to channel region 120 (by or through portion 111) due to having a larger lattice constant than portion 111. View 102 shows an enlarged perspective of source or drain region 110 between adjacent nanoribbons 125 in adjacent channel regions 120.

IC device 100 includes multiple transistor structures 101, and each structure 101 includes a channel region 120 coupled with and between source and drain regions 110. Each of source and drain regions 110 is coupled with a metallization structure 130. Adjacent source and drain regions 110 may be electrically coupled by conduction of channel regions 120 therebetween. Channel region 120 may be any suitable structure of any suitable material(s). In many embodiments, as shown in the exemplary embodiment of FIG. 1, channel region 120 includes multiple parallel (e.g., mechanically and/or electrically parallel) channel structures, such as nanoribbons 125 in a stack of nanoribbons 125 in region 120. Nanoribbons 125 may be of an arbitrary width and, in some embodiments, may be characterized as either nanowires or nanosheets. In some embodiments, channel region 120 is within a fin, e.g., of silicon. Channel region 120 may be of a same material as substrate 199. For example, channel region 120 may be within a fin or nanoribbon(s) 125 of silicon etched from or grown over a substrate 199 of silicon. In some embodiments, channel region 120 includes a material different from that of substrate 199. In some such embodiments, channel region 120 includes nanoribbon(s) 125 of silicon germanium over a silicon substrate 199.

Transistor structure 101 includes source and drain regions 110 coupled with the stack of nanoribbons 125 of channel region 120, on both ends of channel region 120. The location and orientation of channel region 120 (e.g., with a longitudinal axis of channel region 120 extending between source and drain regions 110, in the direction of current flow) may allow for the compression of channel region 120 by source and drain regions 110 coupled on both ends of channel region 120. Source or drain region 110 may be of a crystalline material (e.g., epitaxially formed to exert an outward, compressive force), such as of a semiconductor material. Semiconductor or crystalline region 110 may be of any suitable (e.g., suitably conductive) material. Any given source or drain region 110 may be coupled to channel regions 120 in adjacent transistor structures 101, and may be a source region 110 in one transistor structure 101 and a drain region 110 in another transistor structure 101. A source or drain region 110 may be a source region 110 in (and coupling) multiple transistor structures 101 or a drain region 110 in (and coupling) multiple structures 101.

For example, in the exemplary embodiment of FIG. 1, view 102 is centered on a source or drain region 110 between and coupled with both of first and second channel regions 120 in respective first and second transistor structures 101. Source or drain region 110 is between and coupled with first and second stacks of nanoribbons 125 of the first and second channel regions 120. The source or drain region 110 of view 102 is in both of first and second transistor structures 101. Source and drain regions 110 include first and second portions 111, 112. First portion 111 is a layer or liner portion 111 that includes a substantially horizontal sector 113 and a substantially vertical sector 114. First portion 111 is a layer or liner portion 111 that makes up a sidewall of source or drain region 110 (e.g., in vertical sector(s) 114). Substantially horizontal sector 113 may couple vertical sectors 114 on both sidewall of region 110. In a cross-section of source or drain region 110 (e.g., including at least portions of channel regions 120 to either side of region 110), first portion 111 may be a continuous U-shaped material structure. For example, a substantially horizontal sector 113 may be between and coupled (e.g., connected) to a pair of substantially vertical sectors 114 extending up from sector 113. Source or drain region 110 and portion 111 (and the pair of vertical sectors 114, collectively) may be symmetrical about horizontal sector 113 and a vertical centerline of region 110 and sector 113.

Second portion 112 may be an intervening or central bulk or fill portion 112 within or enclosed by liner portion 111. First portion 111 is on both sides of second portion 112; second portion 112 is within and between first portion 111. As illustrated in view 102, source or drain region 110 includes first portion 111 on either side of second portion 112, between second portion 112 and the first channel region 120, and between second portion 112 and the second channel region 120. First portion 111 is between second portion 112 and both stacks of nanoribbons 125.

First portion 111 may be a liner layer forming a sidewall of source or drain region 110. Sidewall liner portions 111 of source or drain region 110 are in contact with nanoribbons 125 and spacer material 140 between nanoribbons 125 (e.g., at vertical sector(s) 114). First liner portion 111 and vertical sector 114 are continuous along height H₁ of channel region 120 at least between top and bottom nanoribbons 125A, 125B of the stack of nanoribbons 125, e.g., from a lower surface 128 of bottom nanoribbon 125B to an upper surface 127 of top nanoribbon 125A. In many embodiments, portion 111 and sector 114 are continuous along a height greater than height H₁, e.g., from substrate 199 to above upper surface 127 of channel region 120. In some such embodiments, upper surface 127 of channel region 120 is upper surface 127 of a fin channel region 120.

In many embodiments, first portion 111 and sector 114 include a monocrystalline span at least along height H₁ of channel region 120, between top and bottom nanoribbons 125A, 125B of the stack of nanoribbons 125, e.g., from a lower surface 128 of bottom nanoribbon 125B to an upper surface 127 of top nanoribbon 125A. In many embodiments, portion 111 and sector 114 include a monocrystalline span from substrate 199 to above upper surface 127 of channel region 120. A monocrystalline span is a continuous crystal lattice uninterrupted by a grain boundary within the height. In many embodiments, first portion 111 and sector 114 are substantially monocrystalline at least between top and bottom nanoribbons 125A, 125B of the stack of nanoribbons 125, e.g., from a lower surface 128 of bottom nanoribbon 125B to an upper surface 127 of top nanoribbon 125A. In many embodiments, portion 111 and sector 114 are substantially monocrystalline from substrate 199 to above upper surface 127 of channel region 120. A substantially monocrystalline portion 111 and sector 114 may be monocrystalline along a span or height of portion 111 and sector 114 with grain boundaries only along a periphery of portion 111 and sector 114. For example, some grain boundaries may be present adjacent a joining of sector 114 and nanoribbons 125, including portions of sector 114 adjacent nanoribbons 125 that grow together independently of bottom-up growth from sector 113. A substantially monocrystalline portion 111 and sector 114 may be monocrystalline over 90% or more of a cross-section of region 110 including both of portions 111, 112. A continuous, monocrystalline liner portion 111 and sector 114 spanning at least the height H₁ of channel region 120 (or at least a liner portion 111 having a monocrystalline span along height H₁ of channel region 120) may advantageously enable the transmission of substantially uniform compressive strain along the height H₁ of channel region 120, e.g., substantially uniform compressive strains to each of multiple nanoribbons 125 in channel region 120.

Liner portion 111 and substantially horizontal sector 113 are in contact with substrate 199 under source or drain region 110. First portion 111 may be substantially monocrystalline, and portion 111 and substrate 199 may have substantially aligned crystal lattices. For example, first portion 111 may be grown from substrate 199, which may provide a template or seed material from which source or drain region 110 may be epitaxially grown and with which source or drain region 110 may be aligned. First portion 111 and substrate 199 may have differing lattice constants (e.g., portion 111 may have a lattice constant greater than a lattice constant of substrate 199), but may have crystal lattices substantially aligned at an interface between portion 111 and substrate 199. First portion 111 having a lattice constant greater than that of substrate 199 may beneficially enable the exerting of a compressive strain on channel region 120.

In many embodiments, sector 113 of liner portion 111 adjacent substrate 199 has a vertical thickness T₁ greater than a lateral thickness T₂ of sector 114 adjacent channel region 120. For example, liner portion 111 may be grown bottom-up, e.g., from substrate 199 to upper surface 127 (or above upper surface 127) of channel region 120, with growth conditions preferential to (e.g., (001) epitaxial) growth upwards from substrate 199. These conditions may result in a thicker thickness T₁ (of sector 113 over substrate 199) greater than a thinner lateral thickness T₂ of vertical sector 114 (adjacent channel region 120 and a sidewall of source or drain region 110). In some embodiments, thickness T₁ of sector 113 is 10 nm or greater, which may provide an appropriate height from substrate 199 to adjacent channel region 120. In some such embodiments, thickness T₁ of sector 113 is 50 nm or greater, which may provide sufficient height from substrate 199 to channel region 120, e.g., for a larger region 110, for example, in a deeper trench in substrate 199.

In some embodiments, lateral thickness T₂ of vertical sector 114 (adjacent channel region 120 and a sidewall of source or drain region 110) is 10 nm or less. A small thickness T₂ (e.g., of 10 nm or less) may advantageously allow for a highly conductive intervening portion 112 within liner portion 111 and, in many embodiments, a low resistivity contact for source or drain region 110. In some embodiments, for example, in embodiments having less lateral space between adjacent channel regions 120, lateral thickness T₂ of vertical sector 114 is 2 nm. A larger thickness T₂ (e.g., of 10 nm or more), for example, in embodiments having a larger lateral space between adjacent channel regions 120, may provide sufficient lateral space for a highly conductive intervening portion 112 while offering a more mechanically robust vertical sector 114 for transmitting compressive strain from portion 112 to channel region 120.

In some embodiments, a ratio of thickness T₁ to thickness T₂ is about 5:1 (e.g., greater than 4:1 and less than 6:1). Such a ratio may beneficially provide increasing mechanical robustness of vertical sectors 114 as crystalline region 110 and compression-exerting portion 112 (and sector 113) scale up in size.

In some embodiments, source or drain region 110 consists of liner portion 111 (in contact with spacer material 140 and one or more channel regions 120, e.g., on two sides of region 110, and up to a top of height H₁) and intervening portion 112 (within liner portion 111 and up to the top of height H₁ or below the top of height H₁). In some embodiments, as in the exemplary embodiment of FIG. 1, a top of intervening portion 112 is over a top of liner portion 111, and, e.g., intervening portion 112 is in contact with spacer material 140 over channel regions 120.

Second or intervening portion 112 may be grown from (e.g., deposited on) first or liner portion 111, whose substantially monocrystalline lattice may provide a high-quality growth template for epitaxial growth of portion 112. Liner and intervening portions 111, 112 may have crystal lattices substantially aligned at an interface between portions 111, 112. First and second portions 111, 112 may be formed by separate or distinct operations, e.g., with different reactants and/or conditions. First and second portions 111, 112 may have the same or differing compositions. For example, second portion 112 may have different (e.g., additional) constituent elements and/or have the same constituent elements, but in different proportions (e.g., atomic concentrations). In some embodiments, intervening portion 112 has a lattice constant greater than a lattice constant of liner portion 111. Second portion 112 having a lattice constant greater than that of first portion 111 may advantageously enable the exerting of a compressive strain on channel region 120 (e.g., through or by way of liner portion 111).

Source or drain region 110 may advantageously include germanium, which has a lower resistivity than some notable other semiconductor materials, such as silicon. Germanium also has a greater lattice constant than silicon, which may enable the exerting of a compressive strain on channel region 120. In many embodiments, crystalline region 110 includes germanium, for example, in a source or drain region 110 of silicon germanium (e.g., an alloy, Si₁₋ₓGeₓ). In many embodiments, both liner and intervening portions 111, 112 include silicon and germanium. In some embodiments, liner and intervening portions 111, 112 include silicon and germanium in approximately the same proportions (e.g., atomic concentrations). In regions 110 of silicon germanium, an average lattice constant for a given sample (e.g., a given cross-section) is closely related to the relative proportions (e.g., atomic concentrations) of silicon and germanium. In some embodiments, portions 111, 112 both include silicon and germanium, and intervening portion 112 includes a greater atomic concentration of germanium than liner portion 111. Such a configuration may ensure that intervening portion 112 of region 110 has a greater average lattice constant than liner portion 111 (e.g., under portion 112, where portion 112 is laterally aligned with portion 111), and that portion 112 exerts an expansive force laterally, which may be then be evenly distributed along a full height H₁ of adjacent channel region(s) 120 by liner portion(s) 111. In many embodiments, both portions 111, 112 include silicon and germanium, and both portions 111, 112 (and region 110 as a whole) have an average lattice constant greater than substrate 199.

In some embodiments, source or drain region 110 includes silicon germanium, Si₁₋ₓGeₓ, with a cross-section having an average atomic concentration of germanium of approximately 60% (e.g., x = 0.6; Si_{0.4}Ge_{0.6}). This atomic concentration may be a weighted average across the cross-section of region 110 and reflect the proportions of portions 111, 112 in the cross-section. This atomic concentration may provide an optimal balance of high conductivity of region 110, sufficiently high average lattice constant of region 110, and acceptable processing conditions (e.g., sufficiently low processing time for high-quality film portion 111).

Germanium may provide increases in conductivity and lattice constant. In embodiments of region 110 including silicon germanium, portions 111, 112 may have different average atomic concentrations of germanium. Liner portion 111 may have a lower proportion of germanium than portion 112 (e.g., at or between 5% and 40%; in silicon germanium, Si₁₋ₓGeₓ, x = between 0.05 and 0.4, inclusive), which may allow for film portion 111 to be epitaxially grown to sufficient thickness without dislocations or other defects. For example, when in contact with silicon nanoribbons 125 and substrate 199, liner portion 111 having a lower proportion of germanium also has a lower lattice mismatch with adjacent silicon nanoribbons 125 and substrate 199, and a larger allowable or critical thickness above which dislocations may occur. In some embodiments, liner portion 111 includes germanium at an atomic concentration of 5% (e.g., Si_{0.05}Ge_{0.05}), which may provide sufficiently improved conductivity (relative to silicon) and comfortable margin to a critical film thickness of portion 111. In some embodiments of region 110 including silicon germanium, Si₁₋ₓGeₓ, liner portion 111 includes germanium at an atomic concentration of 40% (e.g., Si_{0.6}Ge_{0.4}), which may provide improved conductivity (relative to lower concentrations) and allow for a sufficient film thickness of portion 111. In some embodiments, liner portion 111 includes germanium at an intermediate atomic concentration of 20% (e.g., Si_{0.8}Ge_{0.2}), which may provide an optimized balance of conductivity and film thickness.

Intervening or fill portion 112 may have a higher proportion of germanium than portion 111 (e.g., 40-80%; in silicon germanium, Si₁₋ₓGeₓ, x = between 0.4 and 0.8, inclusive), which may provide increased conductivity and increased average lattice constant for bulk portion 112 in region 110. In some embodiments, portion 112 includes germanium at an atomic concentration of less than 60%, e.g., 40%, which may provide sufficient conductivity for portion 112 and compression of channel region 120, while also providing relatively low lattice mismatch (e.g., for a relatively large bulk portions 112 or with a liner portion 111 having a relatively low atomic concentration of germanium). In some embodiments, bulk portion 112 includes germanium at an atomic concentration of 60% (e.g., Si_{0.4}Ge_{0.6}), which may provide increased conductivity for portion 112 and compression of channel region 120. In some embodiments, bulk portion 112 includes germanium at an atomic concentration of 80% (e.g., Si_{0.2}Ge_{0.8}), which may maximize compression of channel region 120 and/or conductivity for portion 112. In some embodiments, bulk portion 112 includes germanium at an intermediate atomic concentration of 70% (e.g., Si_{0.3}Ge_{0.7}), which may provide an optimized balance of conductivity and exerted compressive strain.

Source or drain region 110 may include a dopant, e.g., to increase the conductivity of transistor structure 101. In many pMOSFET embodiments, the dopant is a p-type dopant, e.g., any suitable acceptor dopant. In some such embodiments, the dopant is boron, aluminum, or gallium. Other dopants may be deployed in region 110. In many embodiments, source or drain region 110 includes a p-type or acceptor dopant (e.g., boron) in both of portions 111, 112. In some such embodiments, region 110 includes a greater atomic concentration of the dopant in portion 112. In some embodiments, region 110 includes a first atomic concentration of a p-type or acceptor dopant (e.g., boron) in first portion 111 approximately equal to a second atomic concentration of the p-type or acceptor dopant in the second portion 112. In some embodiments, region 110 (e.g., in portion 111 and/or portion 112) includes boron at an atomic concentration of more than 10²¹ atoms/cm³. In some such embodiments, region 110 (e.g., portion 111 and/or portion 112) includes boron at an atomic concentration of 2·10²¹ atoms/cm³ or more.

The atomic concentration of the dopant may advantageously be substantially uniform or even across region 110, or at least substantially uniform across liner portion 111 and substantially uniform across intervening portion 112. Such uniformity may beneficially ensure sufficient conductivity throughout region 110 and of transistor structure 101 as a whole. The doping concentrations in portions 111, 112 may differ due to intentionally different deposition conditions, e.g., to optimize for different processing characteristics, such as growth direction or processing time. Uniform doping concentrations may be verified by sampling at various locations in source or drain region 110, for example, at upper and lower locations. In many embodiments, a first doping concentration in region 110 (e.g., portion 111) adjacent an upper surface 127 of the channel region 120 is approximately equal to a second doping concentration in region 110 (e.g., portion 111) adjacent substrate 199 or a lower surface 128 of the channel region 120. Here, "approximately equal" first and second doping concentrations, e.g., of boron, may be within about a factor of ten. For example, a first doping concentration in region 110 (e.g., portion 111) adjacent an upper surface 127 of the channel region 120 may be approximately 2·10²¹ atoms/cm³, and a second doping concentration in region 110 (e.g., portion 111) adjacent substrate 199 or a lower surface 128 of the channel region 120 may be approximately 2·10²⁰ atoms/cm³. The uniformity of doping concentrations across region 110 (or at least portions 111, 112) may be evidence of epitaxial growth of crystalline region 110 with the dopant, rather than, e.g., the implant and/or diffusion of the dopant into region 110 following formation.

The presence of both boron-10 and boron-11 in region 110 (in at least liner portion 111 or intervening portion 112) may also demonstrate epitaxial growth of region 110 with boron. Unlike a crystalline region 110 implanted (rather than grown) with boron that (due to the mass difference between boron-10 and boron-11) may only include detectable amounts of one isotope, e.g., boron-11, a crystalline region 110 epitaxially grown with boron may include both isotopes (e.g., at about the naturally occurring ratio of boron-11 to boron-10 of ~4:1). In many embodiments, source or drain region 110 includes both boron-10 and boron-11 in region 110, e.g., having a detectable atomic concentration of boron-10 in liner portion 111, for example, greater than 10¹⁷ atoms/cm³. In some such embodiments, region 110 includes boron-11 and boron-10 at a ratio of boron-11 to boron-10 greater than 2:1 and less than 6:1. In some such embodiments, region 110 includes boron-11 and boron-10 at a ratio greater than 3:1 and less than 5:1. In some such embodiments, region 110 includes boron-11 and boron-10 at relative proportions approximately equal to the naturally occurring ratio of about 4:1.

Substrate 199 may include any suitable material or materials in any suitable structure, such as a wafer, die, etc. Substrate 199 may include a semiconductor material that transistors can be formed out of and on, including a crystalline material, such as monocrystalline or polycrystalline silicon (Si), germanium (Ge), silicon germanium (SiGe), a III-V alloy material (e.g., gallium arsenide (GaAs)), a silicon carbide (SiC), a sapphire (Al₂O₃), or any combination thereof. In many embodiments, substrate 199 includes crystalline silicon, and other components in or on substrate 199 (such as nanoribbons 125, fins, etc.) also include silicon. Substrate 199 may be a silicon-on-insulator (SOI) substrate 199. In many embodiments, substrate 199 includes a crystalline material capable of acting as a seed or template material for (e.g., epitaxial) growth of source or drain region (e.g., sector 113 of portion 111), for example, having a satisfactory crystal structure. Substrate 199 may also include semiconductor materials, metals, dielectrics, dopants, and other materials commonly found in IC substrates.

Transistor structure 101 includes a gate electrode 121 and gate dielectric 122 in a gate structure over and adjacent channel region 120. The gate structure includes gate dielectric 122 on channel region 120, e.g., on and around each nanoribbon 125. The gate structure includes gate electrode 121 between adjacent metallization structures 130, and with gate dielectric 122 between gate electrode 121 and channel region 120 (e.g., nanoribbons 125). Gate dielectric 122 provides electrical insulation between channel region 120 and gate electrode 121, and enables electrostatic control of channel region 120 (and of the conduction of region 120) by an electric signal on gate electrode 121. Conduction of channel region 120 may electrically couple adjacent source and drain regions 110 and the respective metallization structures 130 coupled to the source and drain regions 110.

Gate dielectric 122 may have more than one layer. Gate dielectric 122 may be of any suitable material(s). The one or more layers of gate dielectric 122 may include a silicon oxide, silicon dioxide (SiO₂), a silicon oxynitride, etc. Advantageously, gate dielectric 122 includes a high-permittivity ("high-K") dielectric (for example, having a dielectric constant over 6). A high-K dielectric material may include one or more of various elements, such as hafnium, silicon, oxygen, titanium, tantalum, lanthanum, aluminum, zirconium, barium, strontium, yttrium, lead, scandium, niobium, and zinc. Gate dielectric 122 may include a dopant, e.g., for elevated permittivity.

Gate electrode 121 is on gate dielectric 122 and may include of at least one of a p- or an n-type work function metal (WFM), depending on whether the transistor is a pMOS or nMOS transistor. In some embodiments, gate electrode 121 is a stack of two or more metal layers, where one or more metal layers are WFM layers and at least one metal layer is a fill metal layer. In a pMOS transistor, for example, metals that may be utilized for gate electrode 121 include, but are not limited to, ruthenium, palladium, platinum, cobalt, nickel, and conductive metal oxides, e.g., ruthenium oxide. A p-type metal layer will enable the formation of a pMOS gate electrode 121 with a work function that is between about 4.9 eV and about 5.2 eV. These or other metals may be deployed in gate electrode 121 in an nMOS transistor, including hafnium, zirconium, titanium, tantalum, aluminum, alloys of these metals, carbides of these metals (such as hafnium carbide, zirconium carbide, titanium carbide, tantalum carbide), etc. An n-type metal layer will enable the formation of an nMOS gate electrode 121 with a work function that is between about 3.9 eV and about 4.2 eV.

Metallization structure 130 may be a conductive (e.g., metal) structure that contacts source or drain regions 110. Structures 130 may couple regions 110 (and transistor structures 101) to interconnect layers and networks, e.g., over transistor structures 101. For example, structures 130 may be via structures 130. Metallization structures 130 may include any suitable material(s). In some embodiments, structures 130 include a stack of two or more metal layers, where at least one metal layer is a liner layer, and at least one metal layer is a fill metal layer. In many embodiments, structures 130 include one or more of copper, gold, tantalum, cobalt, tungsten, ruthenium, molybdenum, aluminum, and nickel, including in alloys. In some embodiments, structures 130 include nitrides of metals, e.g., tantalum and titanium. Structures 130 may include other electrically conductive materials, including non-metals.

Spacer material 140 is an (e.g., electrically) insulating material between gate electrode 121 and adjacent metallization structures 130 and between gate electrode 121 and adjacent source and drain regions 110. Channel region 120 extend through material 140 to couple gate electrode 121 and adjacent source and drain regions 110. Spacer material 140 may be any suitable material (e.g., suitably electrically insulating). Spacer material 140 may advantageously be a low-permittivity dielectric material.

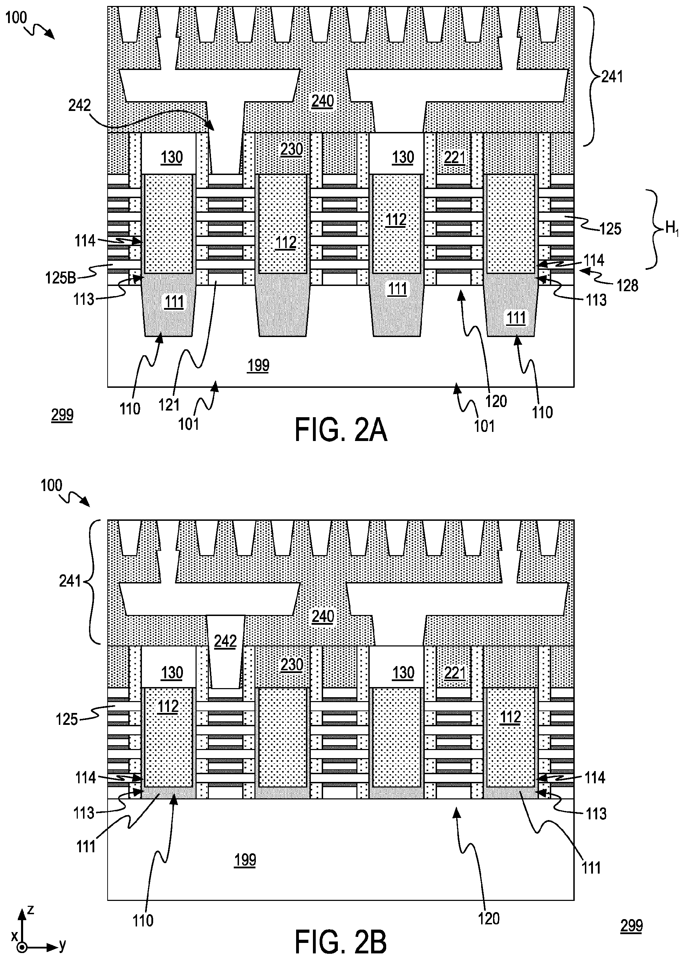

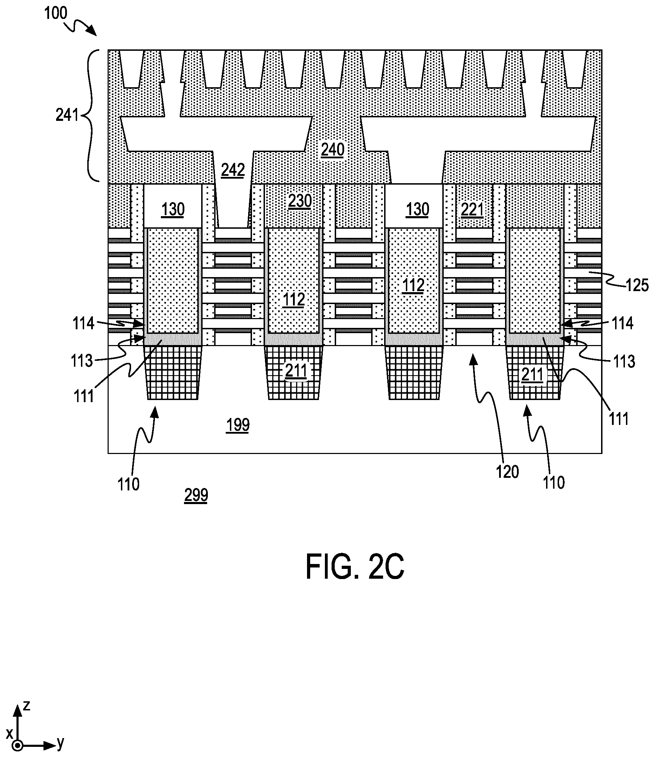

FIGS. 2A, 2B, and 2C illustrate cross-sectional profile views of transistor structures 101 having various source and drain regions 110 in IC devices 100, in accordance with some embodiments. FIGS. 2A-2C show transistor structures 101 with differently structured substrates 199 and regions 110 (including various portions 111 and sectors 113). In many embodiments, source and drain regions 110 (including sectors 113 of portions 111) are grown from substrate 199, and various complementary regions 110 may be deployed to correspond to structures of substrate 199.

Sector 114 of liner portion 111 is in contact with nanoribbons 125 of channel region 120. Sector 114 extends above and below channel region 120 (e.g., top of bottom sector 113 of portion 111 is below bottom surface 128 of channel region 120), which may ensure that intervening portion 112 exerts a substantially uniform strain on each of nanoribbons 125. That sector 114 extends below channel region 120 (and the top of sector 113 is below bottom surface 128 of channel region 120) also ensures that portion 112, which may have a higher conductivity than portion 111, is adjacent all nanoribbons 125 of channel region 120 (including lowest nanoribbon 125B).

IC device 100 is shown with interconnect network 241 coupling transistor structures 101. For example, interconnect network 241 includes contacts or vias 242, which connect to gate electrodes 121 and metallization structures 130. Source and drain regions 110 may be contacted (and coupled to network 241) by metallization structures 130. Metallization contacts, vias 242, and structures 130 may be in, in front of, or behind the y-z viewing plane. Gate electrodes 121 and source and drain regions 110 may be contacted by vias 242, metallization structures 130, etc., through dielectric materials 221, 230 over gate electrodes 121 and source and drain regions 110, respectively. Interconnect network 241 includes metal lines and vias extending through a dielectric material 240 over transistor structures 101. Interconnect network 241 may be on a front- or back-side of substrate 199, and device 100 may include interconnect networks on both front- and back-sides of substrate 199. Transistor structures 101 may be coupled to a power supply (not shown) through interconnect network 241. IC device 100 (and structures 101) may be coupled to a power supply on or through a host component 299 coupled to substrate 199.

Host component 299 is a planar platform or substrate and may include dielectric and metallization structures. Host component 299 may mechanically support, and electrically couple to, substrate 199. At least one side of host component 299 includes interconnect interfaces, e.g., for soldering or direct bonding to one or more IC dies or other substrates. The opposite side of host component 299 may include similar interfaces or, e.g., copper pads for socketing or solder bumps for bonding to another substrate or host component, for example, a printed circuit board. Host component 299 may be any platform with interconnect interfaces, such as a package substrate or interposer, another IC die, etc. Host component 299 may itself be a die or an insulating substrate. Host component 299 may bond to any platform, such as a package substrate or interposer, another IC die, etc. In many embodiments, substrate 199 is an IC die, and host component 299 is a package substrate or interposer. Host component 299 may be above or below device 100, and interconnect network 241 may be between transistor structures 101 and host component 299.

FIG. 2A illustrates source and drain regions 110 (and portions 111) extending below channel regions 120 and gate electrodes 121. Channel regions 120 (e.g., in nanoribbons 125) may be in fins in or on substrate 199. Source and drain regions 110 (e.g., portions 111) may be in trenches between the fins, for example, made by fin cuts or etches into substrate 199 and separating the fins. Source and drain regions 110 (e.g., portions 111) may be grown from substrate 199, e.g., at trench bottoms, up to between or adjacent channel regions 120. Accordingly, the depth of etches in substrate 199 may be set in coordination with growth rates of regions 110 (e.g., portions 111) to optimize the relative dimensions of portions 111, 112 (and sectors 113, 114) for properly straining channel regions 120. For example, an etch in substrate 199 may be sufficiently deep below region 120 to ensure sector 113 of portion 111 is below region 120 and sector 114 spans at least a full height H₁, e.g., from below to above channel region 120.

FIG. 2B shows shorter source and drain regions 110, with bottoms of regions 110 and gate electrodes 121 approximately aligned, and with correspondingly thinner sectors 113 of portions 111. An etch depth between in substrate 199 channel regions 120 may be minimized to minimize a corresponding height or thickness of sector 113 of region 110 and portion 111, while still ensuring satisfactory relative dimensions of portions 111, 112 (and sectors 113, 114) for properly straining channel regions 120. A reduced height or thickness of sector 113 may beneficially result in reduced processing time (e.g., in forming sector 113 on or over template or seed substrate 199).

FIG. 2C illustrates source and drain regions 110 and portions 111 similar to those of FIG. 2B, but with regions 110 and portions 111 over material 211. Material 211 may be a template or seed material on substrate 199, e.g., deposited in trenches in substrate 199, and used for epitaxially forming regions 110 and portions 111. Material 211 may, as a template or seed material, advantageously enable a certain lattice orientation, e.g., an orientation different than if grown directly from substrate 199. In some embodiments, a template or seed material 211 is over substrate 199, under and between channel regions 120, e.g., extending horizontally, under and parallel to nanoribbons 125. Material 211 may substantially fill a fin cut or etch into substrate 199 and so may allow for both a minimally thick sector 113 over material 211 and a deeper fin cut or etch into substrate 199.

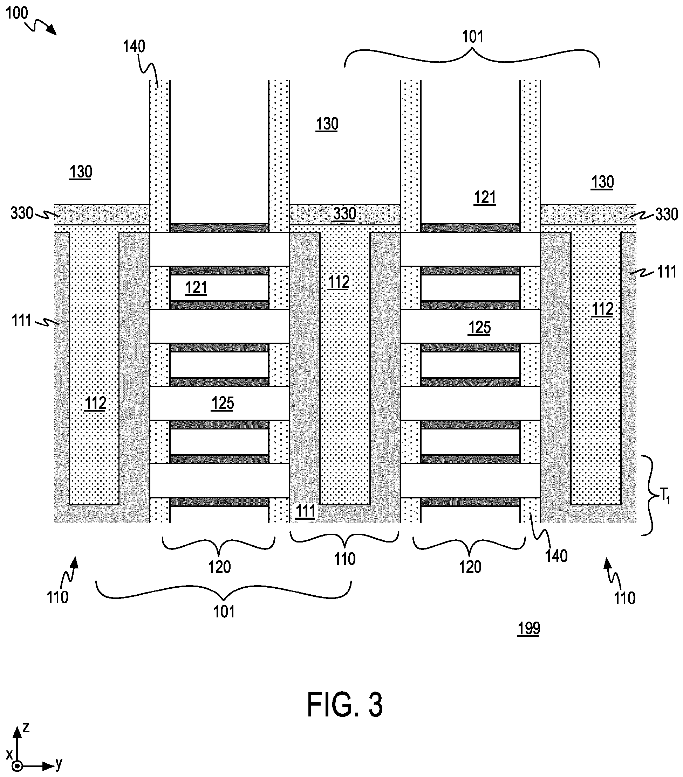

FIG. 3 illustrates a cross-sectional profile view of source or drain region 110 coupled with metallization structure 130 by a highly conductive contact section 330, in accordance with some embodiments. Section 330 may be a relatively thin, upper layer of source or drain region 110 (e.g., in or on portion 112) that provides a low-resistivity contact area for interfacing between region 110 and structure 130. In some embodiments, section 330 has additional dopant content and elevated conductivity. In some embodiments, section 330 has a dopant not present elsewhere in region 110. In some embodiments, the additional dopant content of section 330 is within a layer, e.g., within 10 nm of metallization structure 130. In some such embodiments, the additional dopant content of section 330 is within 5 nm of metallization structure 130. In some embodiments, contact or interface section 330 has a low contact resistivity, for example, a contact resistivity ρ_{c} < 2e-9 Ω·cm².

In some embodiments, section 330 is a thin layer in or on portion 112 of region 110 and in contact with metallization structure 130. In some such embodiments, section 330 is in or on portion 112, a first dopant is uniformly distributed throughout portion 112, and section 330 includes a second dopant not substantially present in portion 112 (except, in some embodiments, in section 330). In some such embodiments, the first dopant is boron, and the second dopant is gallium. A second dopant present in section 330 but otherwise not substantially present in portion 112 might be present outside of section 330 at an atomic concentration of less than 1% of the atomic concentration within section 330. In some embodiments, section 330 is on portion 112, a dopant is uniformly distributed throughout portion 112, and section 330 includes a higher concentration of the dopant than is present in portion 112. In some such embodiments, the dopant concentration in section 330 is twice or more than the dopant concentration in portion 112.

Section 330 may have a similar composition and structure as adjacent sections or portions of region 110, but, e.g., with additional dopant content. The additional dopant content may be of a second dopant, such as gallium or other dopant that may increase the conductivity of section 330 beyond a saturation threshold of a first dopant. For example, in embodiments having a crystalline portion 112 of region 110 of Si_{0.3}Ge_{0.7} and a doping concentration of boron of approximately 10²¹ atoms/cm³, a crystalline section 330 in or on portion 112 may be of Si_{0.3}Ge_{0.7}, a doping concentration of boron of approximately 10²¹ atoms/cm³, and a doping concentration of gallium of approximately 10²⁰ atoms/cm³. In some such embodiments, the gallium included in section 330 is within 10 nm of metallization structure 130. In some such embodiments, the gallium included in section 330 is within 5 nm of metallization structure 130. Any suitable dopants may be deployed in section 330. In some embodiments, section 330 includes gallium at an atomic concentration of approximately 5·10¹⁹ atoms/cm³. In some embodiments, section 330 includes gallium at an atomic concentration of approximately 5·10²⁰ atoms/cm³.

Section 330 may be a layer of additional dopant content in region 110 adjacent to, or overlapping with, portions 111 and/or 112. In some embodiments, section 330 is formed from portions 111 and/or 112 by the addition of another dopant. Any suitable means of formation may be utilized.

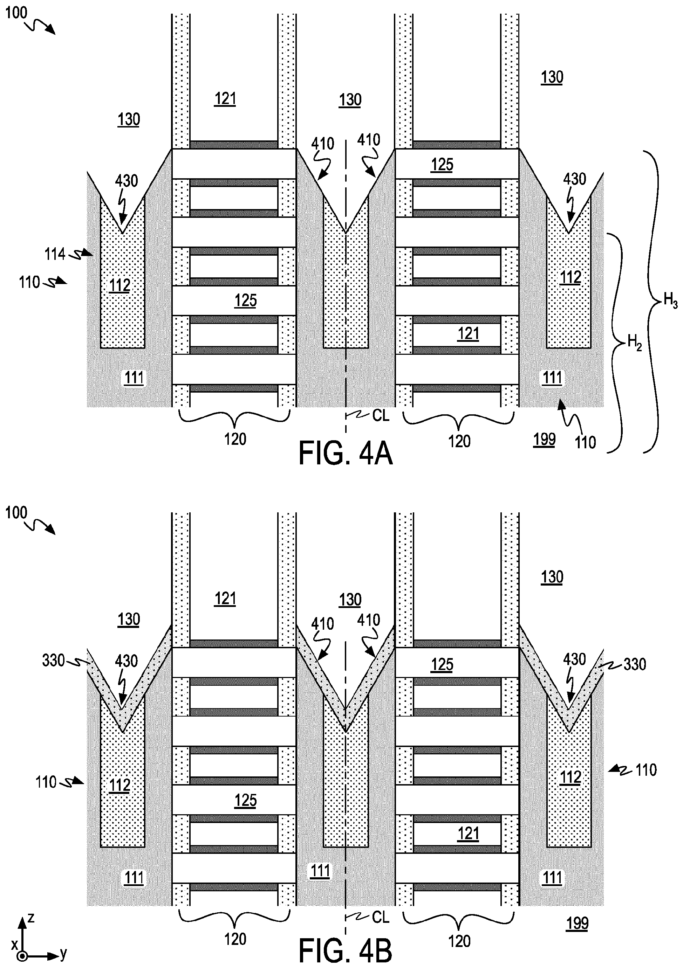

FIGS. 4A and 4B illustrate cross-sectional profile views of metallization structure 130 situated in a notch 430 in source or drain region 110 and between crystallographic facets 410 of region 110, in accordance with some embodiments. Facets 410 and notch 430 may evince the growth process used to form region 110. For example, in embodiments with relatively thick liner sidewall sectors 114 adjacent channel regions 120, downward facets 410 from channel regions 120 (forming notch 430 between channel regions 120) may demonstrate that source or drain region 110 is substantially monocrystalline, e.g., grown bottom-up and epitaxially as a single crystal and with lattice growth saturated in a (111) facet. Conventionally grown source and drain regions may extend upward and outward, e.g., from multiple nanoribbons, and merge into a polycrystalline mass split by multiple grain boundaries. FIGS. 4A and 4B show embodiments with facets 410 that may be in a distinctive crystallographic plane or orientation, such as a (111) plane, e.g., depending on the geometry of adjacent channel regions 120. Other geometries of channel regions 120 (e.g., nanoribbons 125 of different heights and widths) may result in other orientations (such as (001) planes) for facets 410.

FIG. 4A illustrates source and drain regions 110 having facets 410 in contact with metallization structure 130. Facets 410 are surfaces of region 110 oriented along a crystallographic plane of the lattice of substantially monocrystalline region 110. Facets 410 are adjacent metallization structure 130 over source or drain region 110. Source or drain region 110 has a first height H₃ at channel regions 120 (e.g., nanoribbons 125) to both sides. Region 110 has a second height H₂ at centerline CL of drain region 110. First height H₃ is greater than second height H₂. Each of facets 410 are between height H₂ at centerline CL and height H₃ at a respective channel region 120. Facets 410 together form notch 430 between heights H₂, H₃ and between centerline CL and channel region 120.

Besides demonstrating the structure of source or drain region 110, facets 410 and notch 430 may provide improved contact with metallization structure 130. For example, with metallization structure 130 situated in notch 430, region 110 has increased contact surface area (e.g., on or along facets 410) relative to a conventional, horizontal contact surface (e.g., in an x-y plane) occupying the same lateral space (e.g., in the x- and y-directions). Additionally, because of the lower height H₂ at centerline CL of region 110, metallization structure 130 penetrates lower into region 110 between channel regions 120 and has a shorter mean pathlength to nanoribbons 125.

FIG. 4B shows metallization structure 130 in notch 430 and in contact with highly conductive contact section 330 and facets 410 of source and drain regions 110. As previously described, section 330 may be formed by any suitable means and with suitable materials (e.g., dopants). In some embodiments, section 330 is formed from one or both of portions 111, 112 by the addition of another dopant (e.g., gallium).

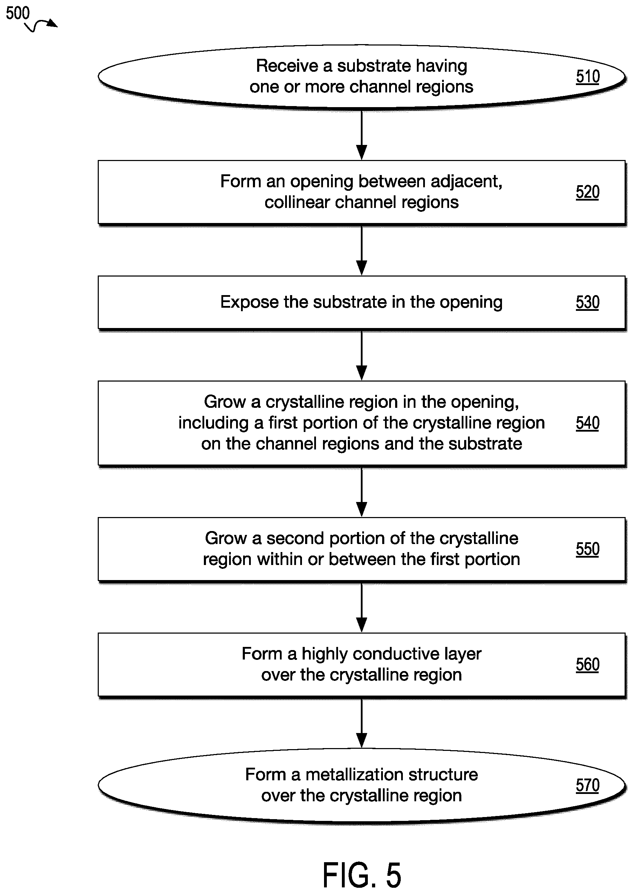

FIG. 5 is a flow chart of methods 500 for forming a substantially monocrystalline source or drain region between adjacent channel regions, in accordance with some embodiments. Methods 500 include operations 510-570. Some operations shown in FIG. 5 are optional. Additional operations may be included. FIG. 5 shows an example sequence, but the operations can be done in other orders as well, and some operations may be omitted. Some operations can also be performed multiple times before other operations are performed. For example, multiple first (or liner) regions may be grown before growing a second, intervening region. Some operations may be included within other operations so that the number of operations illustrated FIG. 5 is not a limitation of the methods 500.

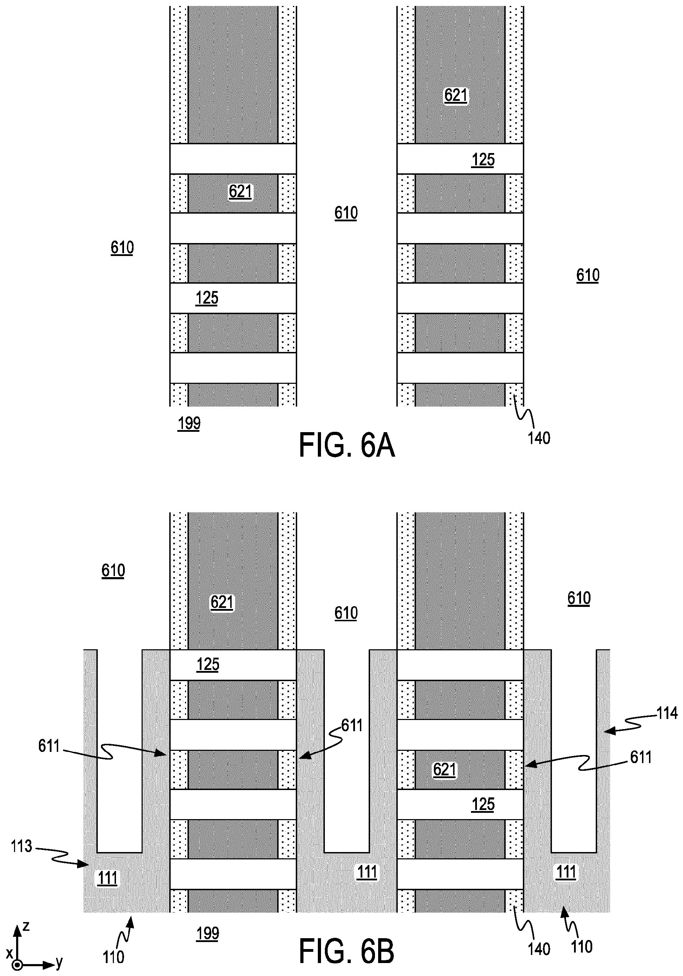

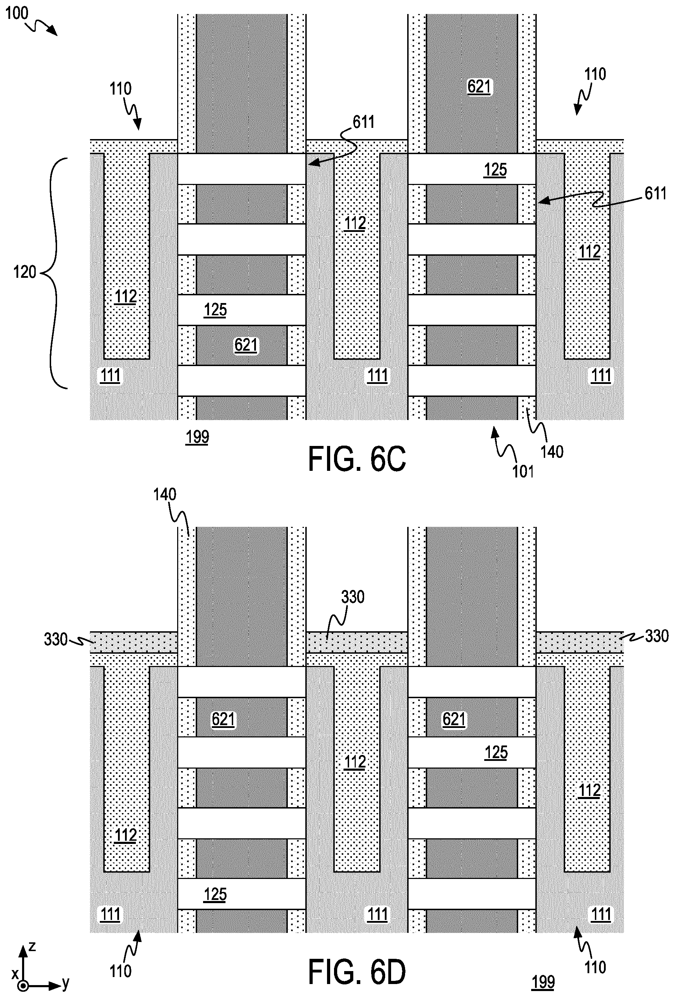

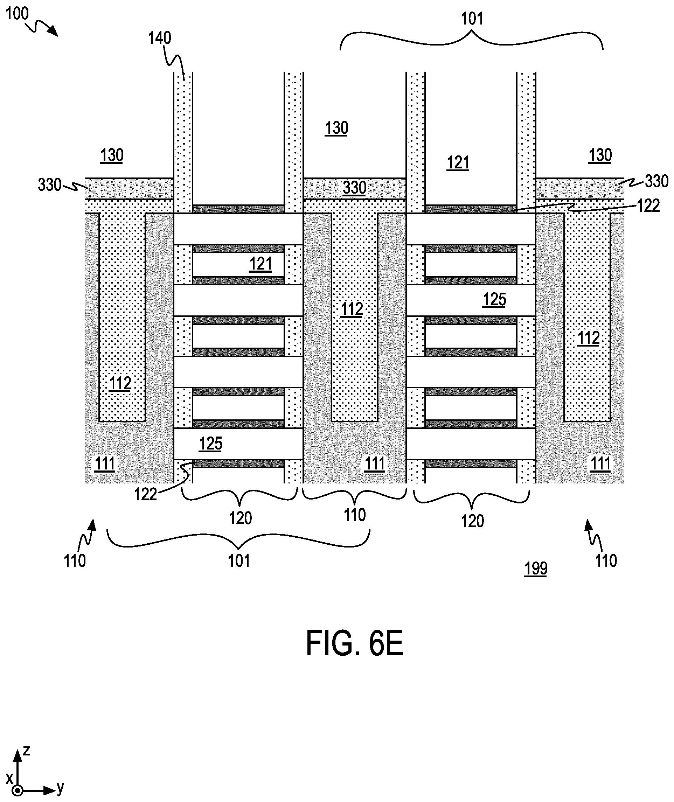

FIGS. 6A, 6B, 6C, 6D, and 6E illustrate cross-sectional profile views of IC device 100 having a substantially monocrystalline source or drain region 110 between adjacent channel regions 120, at various stages of manufacture, in accordance with some embodiments. FIGS. 6A-6E show possible examples of intermediate structures during an embodiment of a practice of methods 500 of FIG. 5.

Returning to FIG. 5, methods 500 begin at operation 510 with receiving a substrate. The substrate may be substantially as previously described (e.g., at least of substrate 199 at FIG. 1). For example, the substrate may include any suitable material or materials in any suitable structure, such as a wafer, die, etc. The substrate may include a semiconductor material that transistors can be formed out of and on, including monocrystalline silicon or silicon germanium, etc. In many embodiments, the substrate includes a crystalline material capable of acting as a seed or template material for (e.g., epitaxial) growth of source and drain regions. The substrate may also include metals, dielectrics, dopants, and other materials commonly found in IC substrates.

In some embodiments, the substrate includes multiple channel regions, such as nanoribbons in adjacent stacks. The channel regions may be in other structures, such as fins. In some embodiments, the multiple channel regions are adjacent and coaxial (e.g., collinear, or aligned on a common axis). For example, multiple fins or stacks of nanoribbons may aligned on a same linear or (e.g., vertical) planar axis. In some embodiments, the channel regions may be formed on the substrate, e.g., by etching fins from or into the substrate, which may include alternating layers of semiconducting material.

Methods 500 continue at optional operation 520 with forming an opening between adjacent, collinear or coaxial channel regions. For example, an opening may be etched or cut in a fin (e.g., a fin having a stack of nanoribbons), which forms adjacent, coaxial channel regions on either side of the fin-cut opening. The opening may have multiple exposed ends of channel regions (e.g., nanoribbons) on both sides of the opening. A source or drain region may be subsequently formed in the opening and in contact with the exposed channel region ends. In embodiments with nanoribbon channel regions in a fin structure, the fin material may be recessed between the nanoribbons, and an insulating spacer material may be deposited in the recess(es) between nanoribbons. The fin material may be sacrificial and may later be removed and replaced with a gate structure (including a gate metal). An insulating spacer material may isolate the gate metal from adjacent source or drain regions.

FIG. 6A illustrates openings 610 between adjacent, coaxial nanoribbons 125 over substrate 199, in accordance with some embodiments, for example, following a performance of receiving and forming operations 510 and 520. Sacrificial material 621 is between (and over and under) nanoribbons 125. Spacer material 140 is also between (and over and under) nanoribbons 125 and between nanoribbons 125 and openings 610. Source or drain regions may be formed in openings 610 and gate electrodes may replace material 621. Insulator material 140 may separate the source or drain regions from the eventual gate electrodes.

Returning to FIG. 5, methods 500 continue with optionally exposing at least a portion of the substrate in the opening at operation 530. The substrate may act as a template or seed material for subsequent (e.g., epitaxial) growth of source and drain regions, and exposing the substrate may ensure that sufficient material is available for templating and that satisfactory growth is enabled. In some embodiments, the substrate is exposed between the adjacent sidewalls (e.g., on either side of an opening between adjacent channel regions), at a bottom of the opening. For example, an etch (or other clearing or cleaning operation) may be performed to remove any material (such as an insulating or spacer material) from the opening and to expose the substrate at the opening bottom. In some embodiments, a template or seed material is deposited over the substrate and between adjacent channel regions. A template or seed material may advantageously enable a lattice orientation different than if grown directly from the substrate. In some embodiments, a template or seed material at least partially fills the opening between adjacent channel regions (e.g., a fin cut or etch into the substrate). Depositing a template or seed material in the opening may allow for a smaller (e.g., minimally thick), subsequently grown epi layer and correspondingly smaller process costs (such as time).

Methods 500 continue at operation 540 by growing a crystalline region in the opening between adjacent channel regions on or over the substrate. In many embodiments, a liner portion of the crystalline region is grown from the substrate, upwards to and above the channel regions. The liner portion may have sidewalls (which are also sidewalls of the crystalline region) in contact with the channel regions and with spacer material between the channel regions. The liner portion may be a first portion that may later contain, and be filled by, a second portion within or between the sidewalls of the liner portion. While the liner portion may grow (e.g., be deposited) on ends of the channel regions (e.g., nanoribbons) somewhat, the liner portion may preferentially grow upwards (from the substrate, rather than laterally from channel regions) to have a vertical thickness over the substrate greater than a horizontal or lateral thickness in from the sidewalls of the crystalline region (in contact with channel regions on both sides). The preferential, upward growth of a high-quality crystalline region may entail more slowly depositing crystal film layers than would otherwise be done. Growth conditions (e.g., chamber temperature and pressure, reactant flow rates, etc.) may be tuned to ensure liner portion grow upwards preferentially at the sidewalls. For example, growth conditions may be adjusted for different template orientations (e.g., of substrate wafers, etc.) to favor upward growth. In many embodiments, upward growth is in the (001) direction, but other lattice orientations may be utilized (e.g., by employment of otherwise oriented substrate wafers, of a template material over the substrate, etc.). The careful growth of the liner portion may result in a substantially monocrystalline lattice without grain boundaries that may then serve as a high-quality growth template for filling in of the liner with a second crystalline portion.

The crystalline region may be grown by any suitable means and with any suitable materials. In many embodiments, the crystalline region is grown by chemical vapor deposition (CVD), for example, by metalorganic CVD (MOCVD, or metalorganic vapor-phase epitaxy (MOVPE)). In many embodiments, the crystalline region is grown (e.g., epitaxially deposited) of silicon and germanium. In some such embodiments, the substrate is silicon, and the crystalline region has an average lattice constant greater than an average lattice constant of the substrate. Other elements may be deployed in the crystalline region.

In many embodiments, the crystalline region is grown by epitaxial deposition of one or more dopants included with the other reactants (e.g., forming the crystal lattice). Crystal growth incorporating a dopant (rather than, e.g., implanting and/or diffusing a dopant into the crystal lattice) may ensure advantageously uniform distribution of the dopant throughout the crystalline region. For example, boron diffusion may be inhibited by germanium, and epitaxial deposition of boron with silicon and germanium into a lattice of the crystalline region may result in improved (e.g., more uniform) distribution of the dopant in the crystalline region (e.g., relative to later implanting and/or diffusing). Uniformity of doping concentration may beneficially ensure sufficient conductivity throughout the crystalline region and a subsequently formed transistor structure as a whole. The uniformity may also be evidence of epitaxial growth of the crystalline region with boron, rather than, e.g., the implant and/or diffusion of boron into the crystalline region following formation. Epitaxially growing the crystalline region with the dopant may also ensure a higher quality crystalline region (e.g., due to the absence of ion implantation which may cause damage to, e.g., defects in, the crystalline lattice) and preclude or minimize the need for a high-temperature anneal (e.g., for diffusion of the dopant or repair of the crystalline structure).

Further evidence of epitaxial growth of the crystalline region with boron may be the isotopes of boron present in the crystalline region. Conventionally, ion implant of boron may include only certain isotopes (e.g., boron-11) because of the differences in mass between, e.g., boron-10 and boron-11. In some embodiments, growing the crystalline region (e.g., the liner portion) includes epitaxially depositing silicon, germanium, boron-10, and boron-11 in the opening between adjacent channel regions and over the substrate. In some such embodiments, boron-11 is present in the crystalline region (e.g., the liner portion) at an atomic concentration greater than three times, and less than five times, the atomic concentration of boron-10 in the crystalline region (e.g., the liner portion). In some such embodiments, boron-11 is present in the crystalline region (e.g., the liner portion) at an atomic concentration approximately four times greater than the atomic concentration of boron-10 in the crystalline region (e.g., the liner portion).

FIG. 6B shows liner portions 111 between, and in contact with, adjacent nanoribbons 125 over substrate 199, in accordance with some embodiments, for example, following a performance of growing operation 540. Sidewalls 611 of portions 111 (and crystalline source or drain regions 110) are in contact with nanoribbons 125 and spacer material 140. Nanoribbons 125 couple adjacent liner portions 111 of regions 110. A horizontal, bottom sector 113 of portion 111 has a greater vertical thickness than lateral thicknesses of vertical, sidewall sectors 114 of portion 111, for example, due to the preferential growth of liner portion 111 upwards from substrate 199.

Returning to FIG. 5, methods 500 continue with growing an intervening, second portion of the crystalline region in the opening (e.g., between sidewalls of the liner portion) at operation 550. The intervening or bulk portion may be grown as crystalline fill within the liner portion, with liner portion sidewalls on two sides, and with the liner portion between the intervening portion and the sidewalls of the crystalline region. The intervening portion may be grown with an average lattice constant greater than an average lattice constant of the liner portion, which may provide a compressive strain on channel regions between adjacent source or drain crystalline regions. In some embodiments, the intervening portion is grown with an average lattice constant approximately equal to an average lattice constant of the liner portion (which may be greater than an average lattice constant of the substrate).

The intervening portion of the crystalline region may be grown by any suitable means and with any suitable materials. In many embodiments, the intervening portion is grown by CVD, e.g., MOCVD or MOVPE. In many embodiments, the intervening portion is grown by epitaxially depositing silicon and germanium. In some such embodiments, the substrate is silicon, and the intervening portion has an average lattice constant greater than an average lattice constant of the liner portion and greater than an average lattice constant of the substrate. For example, in some embodiments, the intervening portion has a greater ratio of germanium to silicon than the liner portion's ratio of germanium to silicon.

In addition to the bulk composition potentially differing from the liner portion (and so the reactant proportions), other processing chamber conditions may differ from those for forming the liner portion (e.g., at growing operation 540). For example, while the formation conditions for the intervening portion may promote the epitaxial filling in of the liner portion within the crystalline region, growth in the upward, (001) (or any other) direction need not be preferred. Growth of the intervening portion may progress from interior surfaces of the liner portion and merge between sidewalls of the liner portion and the crystalline region. The merging of the intervening portion may be into a highly epitaxial, substantially monocrystalline lattice without grain boundaries (or with a single grain boundary or with a few, small grain boundaries) due to the high-quality growth template provided by the substantially monocrystalline liner portion. Growth of the intervening portion may continue further such that a top of the intervening portion is level with a top of the liner portion. In some embodiments, growth of the intervening portion may continue yet further such that a top of the intervening portion is above a top of the liner portion.

The intervening portion of the crystalline region may be grown with a dopant incorporated into the crystal lattice. The atomic concentration of the dopant may advantageously be substantially uniform across the crystalline region, or at least substantially uniform across the liner portion and substantially uniform across the intervening portion. In some embodiments, growing the crystalline region (e.g., the intervening portion) includes epitaxially depositing silicon, germanium, boron-10, and boron-11 in the opening between sidewalls of the liner portion (and the crystalline region). In some such embodiments, boron-11 is present in the crystalline region (e.g., the intervening portion) at an atomic concentration approximately four times greater than the atomic concentration of boron-10 in the crystalline region (e.g., the intervening portion).

FIG. 6C illustrates intervening portion 112 within or between sidewalls 611 of liner portion 111 of crystalline region 110, in accordance with some embodiments, for example, following a performance of growing operation 550. Source and drain regions 110 (e.g., with a greater average lattice constant than substrate 199) may exert a compressive strain on nanoribbons 125 (e.g., channel regions 120). Intervening portions 112 (e.g., with a greater average lattice constant than liner portions 111 and substrate 199) may exert a compressive strain on nanoribbons 125 (e.g., channel regions 120). Substantially monocrystalline liner portions 111 span more than a height of channel regions 120, from below a lowest nanoribbon 125 to at least a highest nanoribbon 125, and may ensure that compressive strain (for example, exerted by intervening portions 112) is distributed uniformly (e.g., evenly) to each of nanoribbons 125.

Returning to FIG. 5, methods 500 continue with optionally forming an interface layer adjacent a top of the crystalline region at operation 560. The interface layer may be a highly conductive contact layer, for example, for electrically coupling a metallization structure to crystalline region. In some embodiments, the interface layer has a low contact resistivity, for example, a contact resistivity ρ_{c} < 2e-9 Ω·cm². In some such embodiments, the interface layer has a contact resistivity ρ_{c} of 1.5e-9 Ω·cm² or 1e-9 Ω·cm². The interface layer may be formed by any suitable means, e.g., with any suitable materials.

In many embodiments, the interface layer is formed by adding a second dopant to the crystalline region, for example, a dopant not already present in the crystalline region. In some such embodiments, the second dopant is gallium. In some embodiments, the interface layer is formed by doping the crystalline region with the second dopant to an atomic concentration of approximately 5·10¹⁹ atoms/cm³. In some embodiments, the interface layer is formed by doping the crystalline region with the second dopant to an atomic concentration of approximately 5·10²⁰ atoms/cm³. The second dopant may be added by diffusing the dopant from an upper surface of the crystalline region, or by an equivalent means. The second dopant may be adsorbed from a precursor gas, deposited on the upper surface, etc., before diffusing into the crystalline region. In some embodiments, the second dopant diffuses only a few nanometers, e.g., 5 nm or 10 nm, into the crystalline region. Any suitable dopant(s) may be deployed, and to any suitable depth. In many embodiments, an upper layer of the source or drain region is removed prior to adding the second dopant to ensure the crystal lattice is exposed for diffusion of the second dopant.

FIG. 6D shows highly conductive contact or interface layer or section 330 in or on crystalline region 110, in accordance with some embodiments, for example, following a performance of optional forming operation 560. Highly conductive section 330 occupies the entire upper surface of crystalline source or drain region 110 and contacts spacer material 140 to both sides of crystalline region 110. In some embodiments, contact or interface section 330 has a low contact resistivity ρ_{c} < 1.5e-9 Ω·cm².

Returning to FIG. 5, methods 500 continue with optionally forming a metallization structure over the crystalline region at operation 570. Forming the metallization structure may be by any suitable means and with any suitable materials, for example, those described of metallization structure 130 at FIG. 1. In some embodiments, the metallization structure includes one or more metal layers deposited over the crystalline region. In some such embodiments, at least one liner (e.g., conformal) layer is first deposited over the crystalline region, and a fill layer is deposited over the liner layer(s). A liner layer may alloy or otherwise bond or interface with an upper surface of the crystalline region, for example, a highly conductive contact or interface layer on or over the crystalline region.

FIG. 6E illustrates source and drain regions 110 in transistor structures 101 and IC device 100, in accordance with some embodiments, for example, following a performance of optional forming operation 570. Source and drain regions 110 (e.g., by portions 112 and through portions 111) may provide substantially uniform (e.g., consistent) strain to each of nanoribbons 125 in channel regions 120. Electrostatic control of transistor structures 101 by gate signals on electrodes 121 electrically couple adjacent structures 130 (or not), including through low-resistivity contact layers or sections 330.

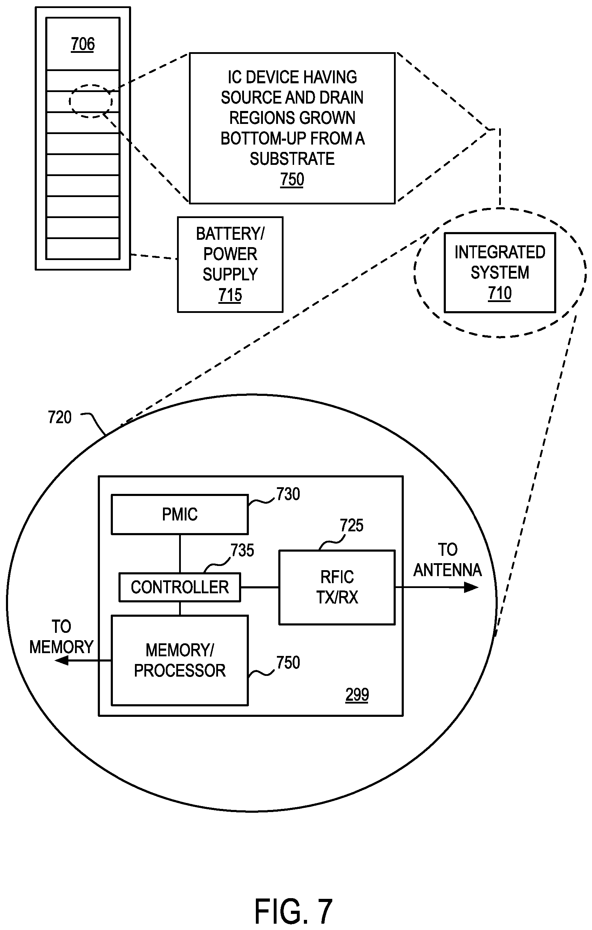

FIG. 7 illustrates a diagram of an example data server machine 706 employing an IC device having source and drain regions epitaxially grown bottom-up, in accordance with some embodiments, e.g., formed by replacing self-assembled monolayer sacrificial materials. Server machine 706 may be any commercial server, for example, including any number of high-performance computing platforms disposed within a rack and networked together for electronic data processing, which in the exemplary embodiment includes one or more devices 750 having source and drain regions grown epitaxially bottom-up.

Also as shown, server machine 706 includes a battery and/or power supply 715 to provide power to devices 750, and to provide, in some embodiments, power delivery functions such as power regulation. Devices 750 may be deployed as part of a package-level integrated system 710. Integrated system 710 is further illustrated in the expanded view 720. In the exemplary embodiment, devices 750 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 750 is a microprocessor including a static RAM (SRAM) cache memory. As shown, device 750 may be an IC device having source and drain regions grown bottom-up and epitaxially, as discussed herein. Device 750 may be further coupled to (e.g., communicatively coupled to) a board, an interposer, or a substrate (such as host component 299) along with, one or more of a power management IC (PMIC) 730, RF (wireless) IC (RFIC) 725 including a wideband RF (wireless) transmitter and/or receiver (TX/RX) (e.g., including a digital baseband and an analog front end module further includes a power amplifier on a transmit path and a low noise amplifier on a receive path), and a controller 735 thereof. In some embodiments, RFIC 725, PMIC 730, controller 735, and device 750 include having epitaxially, bottom-up grown source and drain regions.

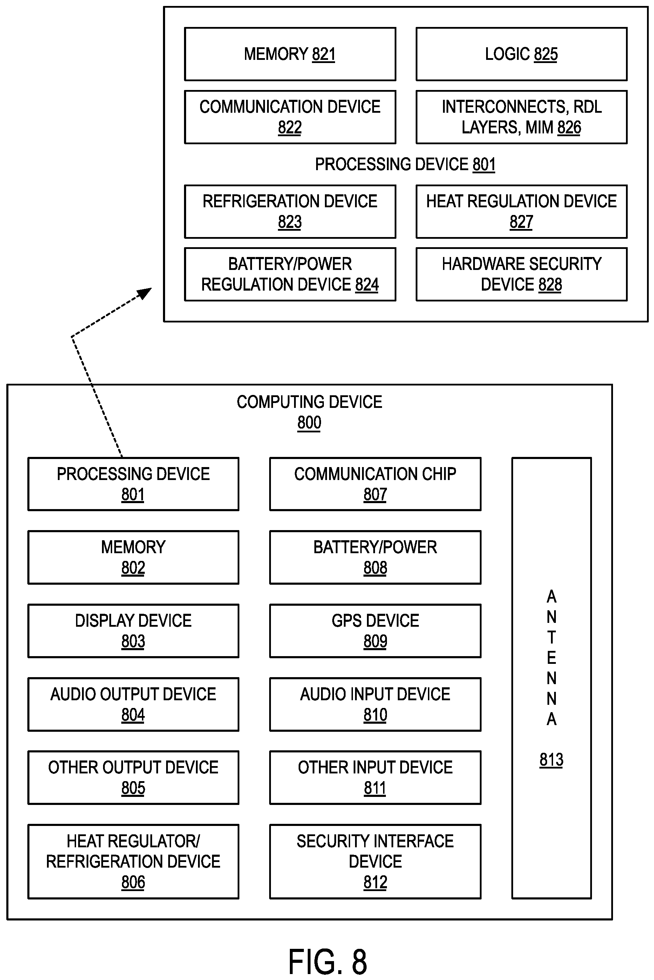

FIG. 8 is a block diagram of an example computing device 800, in accordance with some embodiments. For example, one or more components of computing device 800 may include any of the devices or structures discussed herein. A number of components are illustrated in FIG. 8 as being included in computing device 800, but any one or more of these components may be omitted or duplicated, as suitable for the application. In some embodiments, some or all of the components included in computing device 800 may be attached to one or more printed circuit boards (e.g., a motherboard). In some embodiments, various ones of these components may be fabricated onto a single system-on-a-chip (SoC) die. Additionally, in various embodiments, computing device 800 may not include one or more of the components illustrated in FIG. 8, but computing device 800 may include interface circuitry for coupling to the one or more components. For example, computing device 800 may not include a display device 803, but may include display device interface circuitry (e.g., a connector and driver circuitry) to which display device 803 may be coupled. In another set of examples, computing device 800 may not include an audio output device 804, other output device 805, global positioning system (GPS) device 809, audio input device 810, or other input device 811, but may include audio output device interface circuitry, other output device interface circuitry, GPS device interface circuitry, audio input device interface circuitry, audio input device interface circuitry, to which audio output device 804, other output device 805, GPS device 809, audio input device 810, or other input device 811 may be coupled.

Computing device 800 may include a processing device 801 (e.g., one or more processing devices). As used herein, the term "processing device" or "processor" indicates a device that processes electronic data from registers and/or memory to transform that electronic data into other electronic data that may be stored in registers and/or memory. Processing device 801 may include a memory 821, a communication device 822, a refrigeration device 823, a battery/power regulation device 824, logic 825, interconnects 826 (i.e., optionally including redistribution layers (RDL) or metal-insulator-metal (MIM) devices), a heat regulation device 827, and a hardware security device 828.

Processing device 801 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 800 may include a memory 802, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 802 includes memory that shares a die with processing device 801. This memory may be used as cache memory and may include embedded dynamic random-access memory (eDRAM) or spin transfer torque magnetic random-access memory (STT-MRAM).

Computing device 800 may include a heat regulation/refrigeration device 806. Heat regulation/refrigeration device 806 may maintain processing device 801 (and/or other components of computing device 800) at a predetermined low temperature during operation.

In some embodiments, computing device 800 may include a communication chip 807 (e.g., one or more communication chips). For example, the communication chip 807 may be configured for managing wireless communications for the transfer of data to and from computing device 800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 807 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 807 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 807 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 807 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 807 may operate in accordance with other wireless protocols in other embodiments. Computing device 800 may include an antenna 813 to facilitate wireless communications and/or to receive other wireless communications (such as AM or FM radio transmissions).

In some embodiments, communication chip 807 may manage wired communications, such as electrical, optical, or any other suitable communication protocols (e.g., the Ethernet). As noted above, communication chip 807 may include multiple communication chips. For instance, a first communication chip 807 may be dedicated to shorter-range wireless communications such as Wi-Fi or Bluetooth, and a second communication chip 807 may be dedicated to longer-range wireless communications such as GPS, EDGE, GPRS, CDMA, WiMAX, LTE, EV-DO, or others. In some embodiments, a first communication chip 807 may be dedicated to wireless communications, and a second communication chip 807 may be dedicated to wired communications.

Computing device 800 may include battery/power circuitry 808. Battery/power circuitry 808 may include one or more energy storage devices (e.g., batteries or capacitors) and/or circuitry for coupling components of computing device 800 to an energy source separate from computing device 800 (e.g., AC line power).

Computing device 800 may include a display device 803 (or corresponding interface circuitry, as discussed above). Display device 803 may include any visual indicators, such as a heads-up display, a computer monitor, a projector, a touchscreen display, a liquid crystal display (LCD), a light-emitting diode display, or a flat panel display, for example.

Computing device 800 may include an audio output device 804 (or corresponding interface circuitry, as discussed above). Audio output device 804 may include any device that generates an audible indicator, such as speakers, headsets, or earbuds, for example.

Computing device 800 may include an audio input device 810 (or corresponding interface circuitry, as discussed above). Audio input device 810 may include any device that generates a signal representative of a sound, such as microphones, microphone arrays, or digital instruments (e.g., instruments having a musical instrument digital interface (MIDI) output).

Computing device 800 may include a GPS device 809 (or corresponding interface circuitry, as discussed above). GPS device 809 may be in communication with a satellite-based system and may receive a location of computing device 800, as known in the art.

Computing device 800 may include other output device 805 (or corresponding interface circuitry, as discussed above). Examples of the other output device 805 may include an audio codec, a video codec, a printer, a wired or wireless transmitter for providing information to other devices, or an additional storage device.

Computing device 800 may include other input device 811 (or corresponding interface circuitry, as discussed above). Examples of the other input device 811 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 800 may include a security interface device 812. Security interface device 812 may include any device that provides security measures for computing device 800 such as intrusion detection, biometric validation, security encode or decode, access list management, malware detection, or spyware detection.

Computing device 800, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-8. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a channel region in a transistor structure, and a source or drain region in the transistor structure, coupled with the channel region, the source or drain region including first and second portions, the first portion having a first composition different than a second composition of the second portion, wherein the first portion is in contact with the channel region and in contact with a substrate under the source or drain region, between the second portion and the channel region, and between the second portion and the substrate.

In one or more second embodiments, further to the first embodiments, the first and second portions include silicon and germanium, and the first composition includes a first atomic concentration of germanium less than a second atomic concentration of germanium of the second composition.

In one or more third embodiments, further to the first or second embodiments, the source or drain region includes silicon and germanium and is crystalline, the first portion includes a first average lattice constant, the second portion includes a second average lattice constant, and the second average lattice constant is greater than the first average lattice constant.

In one or more fourth embodiments, further to the first through third embodiments, the source or drain region includes a p-type dopant in the first and second portions, and the source or drain region includes a first atomic concentration of the p-type dopant in the first portion approximately equal to a second atomic concentration of the p-type dopant in the second portion.

In one or more fifth embodiments, further to the first through fourth embodiments, the source or drain region includes a third atomic concentration of the p-type dopant adjacent the substrate, the source or drain region includes a fourth atomic concentration of the p-type dopant adjacent an upper surface of the channel region, and the third and fourth atomic concentrations are approximately equal.

In one or more sixth embodiments, further to the first through fifth embodiments, the source or drain region includes a first p-type dopant in the first and second portions, the transistor structure includes a metallization structure over, and in contact with, the source or drain region, and the source or drain region includes a second p-type dopant in a section adjacent the metallization structure, the second p-type dopant different than the first p-type dopant.

In one or more seventh embodiments, further to the first through sixth embodiments, the source or drain region includes boron in the first and second portions, the source or drain region includes a first atomic concentration of boron-10, the source or drain region includes a second atomic concentration of boron-11, and a ratio of the second atomic concentration to the first atomic concentration is greater than 3:1 and less than 5:1.

In one or more eighth embodiments, further to the first through seventh embodiments, a first sector of the first portion is adjacent the substrate and has a vertical thickness greater than a lateral thickness of a second sector adjacent the channel region.

In one or more ninth embodiments, further to the first through eighth embodiments, the channel region is a first channel region, the transistor structure is a first transistor structure, a second transistor structure includes a second channel region, the source or drain region is between the first and second channel regions, and the first portion is on either side of the second portion, between the second portion and the second channel region.

In one or more tenth embodiments, further to the first through ninth embodiments, the source or drain region includes a first height adjacent the first and second channel regions, a second height at a centerline of the source or drain region, wherein the first height is greater than the second height, and first and second facets adjacent a metallization structure over the source or drain region, the first facet between the centerline and the first channel region, the second facet between the centerline and the second channel region.

In one or more eleventh embodiments, further to the first through tenth embodiments, the channel region includes a stack of nanoribbons, the source or drain region is coupled with the stack of nanoribbons, the first portion is between the second portion and the stack of nanoribbons, and the first portion is substantially monocrystalline between top and bottom nanoribbons of the stack of nanoribbons.

In one or more twelfth embodiments, an apparatus includes first and second stacks of nanoribbons in one or more transistor structures, and a source or drain region between and coupled with the first and second stacks of nanoribbons, the source or drain region including silicon, germanium, and boron in both of a liner portion and an intervening portion, the intervening portion having a greater concentration of germanium than the liner portion, wherein the liner portion is adjacent each of the nanoribbons and adjacent a substrate under the source or drain region, between the intervening portion and the first and second stacks of nanoribbons, and between the intervening portion and the substrate.

In one or more thirteenth embodiments, further to the twelfth embodiments, the liner portion includes a first atomic concentration of boron-10 greater than 10¹⁷ atoms/cm3, and the liner portion includes a second atomic concentration of boron-11 greater than 10¹⁷ atoms/cm3.

In one or more fourteenth embodiments, further to the twelfth or thirteenth embodiments, a ratio of the second atomic concentration to the first atomic concentration is greater than 2: 1 and less than 6: 1.

In one or more fifteenth embodiments, further to the twelfth through fourteenth embodiments, the apparatus also includes a metallization structure over, and in contact with, the source or drain region, wherein the source or drain region includes gallium in a section adjacent the metallization structure.

In one or more sixteenth embodiments, a method includes growing a crystalline region in an opening between first and second channel regions and over a substrate, wherein a first portion of the crystalline region preferentially grows upwards to a first thickness over the substrate greater than a second thickness in from first and second sidewalls of the crystalline region on the first and second channel regions, and growing a second portion of the crystalline region between the first and second sidewalls, the first portion of the crystalline region between the second portion of the crystalline region and the first and second sidewalls, wherein the first portion of the crystalline region has a first lattice constant less than a second lattice constant of the second portion of the crystalline region.

In one or more seventeenth embodiments, further to the sixteenth embodiments, the method also includes forming an interface layer adjacent a top of the crystalline region, wherein the interface layer includes silicon, germanium, and gallium.

In one or more eighteenth embodiments, further to the sixteenth or seventeenth embodiments, growing the crystalline region includes epitaxially depositing silicon, germanium, boron-10, and boron-11 over the substrate.

In one or more nineteenth embodiments, further to the sixteenth through eighteenth embodiments, growing the second portion of the crystalline region includes epitaxially depositing silicon and germanium with the second lattice constant greater than a third lattice constant of the substrate.

In one or more twentieth embodiments, further to the sixteenth through nineteenth embodiments, the method also includes exposing the substrate between the first and second sidewalls, at a bottom of the opening.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a channel region in a transistor structure; and
a source or drain region in the transistor structure, coupled with the channel region, the source or drain region comprising first and second portions, the first portion having a first composition different than a second composition of the second portion, wherein the first portion is:
in contact with the channel region and in contact with a substrate under the source or drain region;
between the second portion and the channel region; and
between the second portion and the substrate.

2. The apparatus of claim 1, wherein:
the first and second portions comprise silicon and germanium; and
the first composition comprises a first atomic concentration of germanium less than a second atomic concentration of germanium of the second composition.

3. The apparatus of either claim 1 or 2, wherein:
the source or drain region comprises silicon and germanium and is crystalline;
the first portion comprises a first average lattice constant;
the second portion comprises a second average lattice constant; and
the second average lattice constant is greater than the first average lattice constant.

4. The apparatus of any one of claims 1-3, wherein the source or drain region comprises a p-type dopant in the first and second portions, and the source or drain region comprises a third atomic concentration of the p-type dopant in the first portion approximately equal to a fourth atomic concentration of the p-type dopant in the second portion.

5. The apparatus of claim 4, wherein:
the source or drain region comprises a fifth atomic concentration of the p-type dopant adjacent the substrate;
the source or drain region comprises a sixth atomic concentration of the p-type dopant adjacent an upper surface of the channel region; and
the third and fourth atomic concentrations are approximately equal.

6. The apparatus of any one of claims 1-5, wherein:
the source or drain region comprises a first p-type dopant in the first and second portions;
the transistor structure comprises a metallization structure over, and in contact with, the source or drain region; and
the source or drain region comprises a second p-type dopant in a section adjacent the metallization structure, the second p-type dopant different than the first p-type dopant.

7. The apparatus of any one of claims 1-6, wherein:
the source or drain region comprises boron in the first and second portions;
the source or drain region comprises a seventh atomic concentration of boron-10;
the source or drain region comprises a eighth atomic concentration of boron-11; and
a ratio of the second atomic concentration to the first atomic concentration is greater than 3:1 and less than 5:1.

8. The apparatus of any one of claims 1-7, wherein a first sector of the first portion is adjacent the substrate and has a vertical thickness greater than a lateral thickness of a second sector adjacent the channel region.

9. The apparatus of any one of claims 1-8, wherein the first portion is a continuous U-shaped material structure in a cross-section of the source or drain region.

10. The apparatus of any one of claims 1-5, wherein:
the channel region is a first channel region;
the transistor structure is a first transistor structure;
a second transistor structure comprises a second channel region;
the source or drain region is between the first and second channel regions;
the first portion is on either side of the second portion, between the second portion and the second channel region; and
the source or drain region comprises:
a first height adjacent the first and second channel regions;
a second height at a centerline of the source or drain region, wherein the first height is greater than the second height; and
first and second facets adjacent a metallization structure over the source or drain region, the first facet between the centerline and the first channel region, the second facet between the centerline and the second channel region.

11. The apparatus of any one of claims 1-10, wherein:
the channel region comprises a stack of nanoribbons;
the source or drain region is coupled with the stack of nanoribbons;
the first portion is between the second portion and the stack of nanoribbons; and
the first portion is substantially monocrystalline between top and bottom nanoribbons of the stack of nanoribbons.

12. A method, comprising:
growing a crystalline region in an opening between first and second channel regions and over a substrate, wherein a first portion of the crystalline region preferentially grows upwards to a first thickness over the substrate greater than a second thickness in from first and second sidewalls of the crystalline region on the first and second channel regions; and
growing a second portion of the crystalline region between the first and second sidewalls, the first portion of the crystalline region between the second portion of the crystalline region and
the first and second sidewalls, wherein the first portion of the crystalline region has a first lattice constant less than a second lattice constant of the second portion of the crystalline region.

13. The method of claim 12, further comprising forming an interface layer adjacent a top of the crystalline region, wherein the interface layer comprises silicon, germanium, and gallium.

14. The method of either claim 12 or 13, wherein growing the crystalline region comprises epitaxially depositing silicon, germanium, boron-10, and boron-11 over the substrate.

15. The method of any one of claims 12-14, wherein growing the second portion of the crystalline region comprises epitaxially depositing silicon and germanium with the second lattice constant greater than a third lattice constant of the substrate.
